# EUROPEAN PATENT APPLICATION

(11) **EP 4 629 794 A1**
(43) Date of publication of application: **08.10.2025**
(21) Application number: 24909215.6
(22) Date of filing: 26.11.2024
(51) Int. Cl.: H10K 30/88

(54) **FLEXIBLE PEROVSKITE PHOTOVOLTAIC DEVICE PACKAGE STRUCTURE AND MANUFACTURING METHOD THEREFOR**

(30) Priority: 27.12.2023 CN 202311815960
(71) Applicant: Xi'an TJ-Solar New Energy Co., Ltd, Xianyang, Shaanxi 712046 (CN)
(72) Inventor: ZHAO, Changzheng, Xianyang, Shaanxi 712046 (CN); LI, Peizhou, Xianyang, Shaanxi 712046 (CN); HAN, Wei, Xianyang, Shaanxi 712046 (CN)
(74) Representative: Berggren Oy
(86) International application number: PCT/CN2024/134579
(87) International publication number: WO 2025/139540

(57) **Abstract**

The present invention belongs to the technical field of solar cell encapsulation, and particularly relates to an encapsulation structure of a flexible perovskite photovoltaic module and a manufacturing method of an encapsulation structure of a flexible perovskite photovoltaic module. By arranging a PI layer on a glass substrate, a technical risk of substrate separation caused by electrostatic dissipation in a process is solved. A barrier layer is arranged between the PI layer and a first electrode layer so as to solve the problem of moisture and oxygen blocking stability of perovskite. By using the glass substrate as a substrate for manufacturing a photovoltaic module, manufacturing precision of the photovoltaic module is improved. When a packaging layer is manufactured, a position for electrode attachment is reserved in advance, such that subsequent electrode printing or attachment is facilitated. A process route of the manufacturing method has mature supporting materials and devices, and mass production is facilitated.

## Description

### Technical Field

The present invention belongs to the technical field of the encapsulation of solar cell, and particularly relates to an encapsulation structure of a flexible perovskite photovoltaic module and a manufacturing method of an encapsulation structure of a flexible perovskite photovoltaic module.

### Background

At present, most of flexible perovskite photovoltaic module substrates are made from flexible plastic substrates through a roll-to-roll process. Due to repeated precise laser etching in the roll-to-roll process, poor repeatability, high difficulty in leading out electrodes, shortage of support equipments and materials for encapsulation, high implementation difficulty, etc are caused.

In view of this, a manufacturing method for a flexible perovskite cell is disclosed in the existing Chinese patent document (with publication number: CN116761485A and publication date: September 15, 2023). As disclosed in the document, a flexible substrate is attached to a glass substrate through electrostatic adsorption, and then peeled off through electrostatic elimination after a manufacturing process is completed. However, how to avoid a technical risk of substrate separation after electrostatic dissipation in the manufacturing process is not considered in the above operation, and encapsulation precision is not considered either. In addition, there have been no mature cases of mass production.

In view of this, the present invention is provided.

### Summary

An objective of the present invention is to overcome the shortcomings of the art known to inventors and provide an encapsulation structure of a flexible perovskite photovoltaic module and a manufacturing method of an encapsulation structure of a flexible perovskite photovoltaic module, so as to solve the problems of electrostatic dissipation and encapsulation precision in a process.

In order to achieve the above objective, some embodiments of the present invention provide the following technical solution:
In one aspect, the present invention provides an encapsulation structure of a flexible perovskite photovoltaic module. The encapsulation structure of a flexible perovskite photovoltaic module includes: a PI layer, a barrier layer, a functional layer, and an encapsulation layer that are sequentially stacked on a glass substrate, where a first protective film is attached to a lower surface of the PI layer, a second protective film is attached to an upper surface of the encapsulation layer, and the functional layer includes a first electrode layer, a hole transport layer HTL, a perovskite layer, an electron transport layer ETL, and a second electrode layer that are stacked on the barrier layer from bottom to top; and
two opposite sides of the first electrode layer are provided with electrode leads respectively used to be in connection to a perovskite solar cell for electric conduction.

Specifically, an area of the second protective film is greater than an area of the encapsulation layer, and the area of the second protective film and the area of the encapsulation layer are both less than an area of the first electrode layer;
The area of the encapsulation layer is greater than an area of the second electrode layer, the area of the second electrode layer is greater than each of an area of the electron transport layer ETL, an area of the perovskite layer, and an area of the hole transport layer HTL, and the electron transport layer ETL, the perovskite layer, and the hole transport layer HTL have identical shapes and areas; and
either side of the second electrode layer is in lap joint with the first electrode layer, and electrodes are led out through the electrode leads at the two sides of the first electrode layer; an area of the barrier layer is greater than or equal to an area of the PI layer, and the area of the PI layer is greater than or equal to the area of the first electrode layer; and an area of the first protective film is equal to the area of the barrier layer.

Specifically, the electrode leads are led out from the two opposite sides of the first electrode layer through methods of printing or attaching auxiliary electrodes.

In the other aspect, the present invention provides a manufacturing method for an encapsulation structure of a flexible perovskite photovoltaic module. The method specifically includes:
step 1, manufacturing a PI layer: coating a glass substrate with a polyamic acid PAA solution, heating to 300°C to 450°C, performing annealing and forming a glass substrate with the transparent PI layer;
step 2, manufacturing a barrier layer: depositing at least one barrier layer for preventing moisture and oxygen permeation on the PI layer, where a thickness of the barrier layer is 100 nm to 500 nm;
step 3, manufacturing a functional layer: sequentially manufacturing a first electrode layer, a hole transport layer HTL, a perovskite layer, an electron transport layer ETL, and a second electrode layer on the barrier layer;
step 4, manufacturing an encapsulation layer: manufacturing thin films on the functional layer by alternately compounding organic layers and inorganic layers by adopting a thin film encapsulation method, reserving positions for printing or attaching electrode leads at the first electrode layer, and attaching a second protective film to an upper surface of the manufactured encapsulation layer, where a material of the inorganic layers includes, but is not limited to, silicon nitride, silicon dioxide, and aluminum trioxide, a material of the organic layers includes, but is not limited to, epoxy resin, organosilicon, propyl ethylacetate, and acrylate, and a material of the second protective film includes, but is not limited to, TPT, TPE, TPC, CPC, PET, PA/PO, and ultra-thin glass;
step 5, manufacturing a flexible substrate: stripping the glass substrate from the PI layer through laser irradiation by using a laser with a wavelength of 308 nm or 354 nm, obtaining the flexible substrate, and attaching a first protective film to a lower surface of the PI layer, where the stripped glass substrate may be reused after cleaned and ground, and a material of the first protective film includes, but is not limited to, TPT, TPE, TPC, CPC, PET, PA/PO, and ultra-thin glass; and
step 6, leading out the electrode leads: leading out the electrode leads from two opposite sides of the first electrode layer by printing or attaching the electrode leads, and completing manufacturing of the encapsulation structure of a flexible perovskite photovoltaic module.

Compared with the art known to inventors, the technical solution according to the present invention has the following beneficial effects:
According to the present invention, by arranging the PI layer on the glass substrate, a technical risk of substrate separation caused by the electrostatic dissipation in the process is solved. The barrier layer is arranged between the PI layer and the first electrode layer so as to solve the problem of moisture and oxygen barrier stability of perovskite. By using the glass substrate as the substrate for manufacturing a photovoltaic module, manufacturing precision of the photovoltaic module is improved. When the encapsulation layer is manufactured, a position for electrode attachment is reserved in advance, such that subsequent electrode printing or attachment is facilitated. Because materials and devices supporting a process route of the manufacturing method are mature, mass production is facilitated.

### Brief Description of the Drawings

The drawings herein are incorporated into the description as a constituent part of the description, and serve to explain principles of the present invention along with the description.

To describe the technical solutions in examples of the present invention or in the prior art more clearly, accompanying drawings required in explanations of the examples or in the prior art will be briefly introduced below. Apparently, a person skilled in the art can still derive other accompanying drawings from these accompanying drawings without creative efforts.

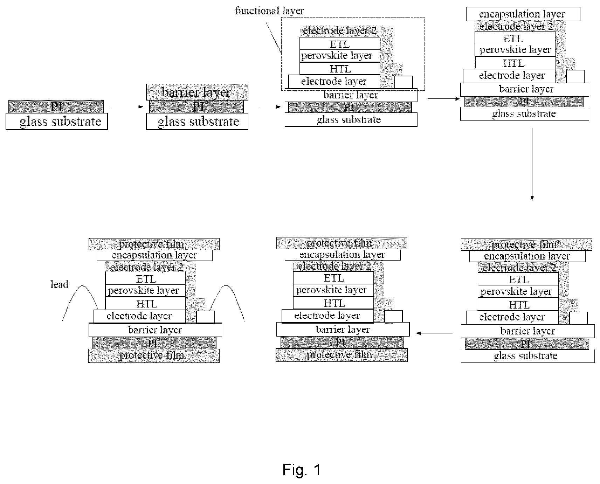

Fig. 1 illustrates a schematic flowchart of manufacturing an encapsulation structure of a flexible perovskite photovoltaic module according to some embodiments of the present invention.

### Detailed Description of the Embodiments

Illustrative examples will be described in detail herein, and their instances are shown in the accompanying drawings. Embodiments described in the following illustrative examples do not represent all embodiments consistent with the present invention. On the contrary, these embodiments are merely instances that are consistent with some aspects of the present invention, as detailed in the appended claims.

In order to make a person skilled in the art better understand the technical solution of the present invention, the present invention will be further described in detail below with reference to accompanying drawings and examples.

### Example 1

This example provides an encapsulation structure of a flexible perovskite photovoltaic module. The encapsulation structure of a flexible perovskite photovoltaic module includes: a PI layer, a barrier layer, a functional layer, and an encapsulation layer that are sequentially stacked on a glass substrate. A first protective film is attached to a lower surface of the PI layer, a second protective film is attached to an upper surface of the encapsulation layer, and the functional layer includes a first electrode layer, a hole transport layer HTL, a perovskite layer, an electron transport layer ETL, and a second electrode layer that are stacked on the barrier layer from bottom to top; and
two opposite sides of the first electrode layer are provided with electrode leads respectively used to be in connection to a perovskite solar cell for electric conduction.

Specifically, an area of the second protective film is greater than an area of the encapsulation layer, and the area of the second protective film and the area of the encapsulation layer are both less than an area of the first electrode layer;
The area of the encapsulation layer is greater than an area of the second electrode layer, the area of the second electrode layer is greater than each of an area of the electron transport layer ETL, an area of the perovskite layer, and an area of the hole transport layer HTL, and the electron transport layer ETL, the perovskite layer, and the hole transport layer HTL have identical shapes and areas; and
either side of the second electrode layer is in lap joint with the first electrode layer, and electrodes are led out through the electrode leads at the two sides of the first electrode layer; an area of the barrier layer is greater than or equal to an area of the PI layer, and the area of the PI layer is greater than or equal to the area of the first electrode layer; and an area of the first protective film is equal to the area of the barrier layer.

Specifically, the electrode leads are led out from the two opposite sides of the first electrode layer through methods of printing or attaching auxiliary electrodes.

### Example 2

With reference to Fig 1, on the basis of Example 1, this example provides a manufacturing method of an encapsulation structure of a flexible perovskite photovoltaic module. The method specifically includes:
step 1, a PI layer is manufactured: a glass substrate is coated with a polyamic acid PAA solution, the polyamic acid PAA solution is heated to polymerize at 300°C to 450°C to form the PI layer (a transparent film layer), annealing is performed and a glass substrate with the transparent PI layer is formed;
Step 2, a barrier layer is manufactured: silicon nitride/aluminum oxide is deposited on an upper surface of the PI layer by CVD/ALD/RPVD and other thin film deposition methods to form the barrier layer to prevent the permeation of moisture and oxygen, and the barrier layer is formed for preventing moisture and oxygen from the PI layer, or preventing moisture and oxygen from air, such that a failure of a perovskite layer caused by the fact that the moisture and the oxygen enter the perovskite layer is avoided, and a thickness of the barrier layer is 100 nm to 500 nm;
Step 3, a functional layer is manufactured: a first electrode layer, a hole transport layer HTL, the perovskite layer, an electron transport layer ETL, and a second electrode layer are sequentially manufactured on the barrier layer;
Step 4, an encapsulation layer is manufactured: thin films are manufactured on the functional layer by alternately compounding organic layers and inorganic layers by adopting a thin film encapsulation method, positions are reserved for printing or attaching electrode leads at the first electrode layer, and a second protective film is attached to an upper surface of the manufactured encapsulation layer for protecting the entire module. In some embodiments, the thin films are manufactured on the functional layer by alternately compounding the organic layers and the inorganic layers by adopting the thin film encapsulation method as follows: on the second electrode layer, a propyl ethylacetate polymer layer is formed followed by a silicon nitride inorganic layer and an acrylate polymer layer. By this design, a basic module is better protected, entry of external moisture and oxygen is prevented, and flexibility of a perovskite solar cell is better improved. A material of the inorganic layers includes, but is not limited to, silicon nitride, silicon dioxide, and aluminum trioxide, a material of the organic layers includes, but is not limited to, epoxy resin, organosilicon, propyl ethylacetate, and acrylate, and a material of the second protective film includes, but is not limited to, TPT, TPE, TPC, CPC, PET, PA/PO, and ultra-thin glass;
Step 5, a flexible substrate is manufactured: the glass substrate is peeled off the PI layer through laser irradiation by using a laser with a wavelength of 308 nm or 354 nm, the flexible substrate is obtained, and a first protective film is attached to a lower surface of the PI layer so as to achieve upper and lower protection. The stripped glass substrate is reused after cleaned and ground, and a material of the first protective film includes, but is not limited to, TPT, TPE, TPC, CPC, PET, PA/PO, and ultra-thin glass;
Step 6, the electrode leads are led out: the electrode leads are led out from two opposite sides of the first electrode layer by printing or attaching the electrode leads so as to be in serial connection to adjacent perovskite solar cell devices conveniently to manufacture a flexible module, and the encapsulation structure of a flexible perovskite photovoltaic module is obtained.

To sum up, the manufacturing method of the present invention is adopted for solving the problem that precision of an existing roll-to-roll process cannot be guaranteed, and solving the technical problem that a substrate is likely to get separated in an electrostatic adsorption process.

The embodiments described above are merely specific embodiments of the present invention for those skilled in the art to understand or implement the present invention. Many modifications to these examples will be apparent to those skilled in the art, and the general principles defined herein can be implemented in other examples without departing from the spirit or scope of the present invention.

It should be understood that the present invention is not limited to contents described above, and various modifications and changes can be made without departing from the scope of the present invention. The scope of the present invention is merely limited by the appended claims.

## Claims

1. An encapsulation structure of a flexible perovskite photovoltaic module, comprising: a PI layer, a barrier layer, a functional layer, and an encapsulation layer that are sequentially stacked on a glass substrate, wherein a first protective film is attached to a lower surface of the PI layer, a second protective film is attached to an upper surface of the encapsulation layer, and the functional layer comprises a first electrode layer, a hole transport layer, a perovskite layer, an electron transport layer, and a second electrode layer that are stacked on the barrier layer from bottom to top; and
two opposite sides of the first electrode layer are provided with electrode leads respectively used to be in connection to a perovskite solar cell for electric conduction.

2. The encapsulation structure of a flexible perovskite photovoltaic module according to claim 1, wherein an area of the second protective film is greater than an area of the encapsulation layer, and the area of the second protective film and the area of the encapsulation layer are both less than an area of the first electrode layer;
the area of the encapsulation layer is greater than an area of the second electrode layer, the area of the second electrode layer is greater than each of an area of the electron transport layer, an area of the perovskite layer, and an area of the hole transport layer, and the electron transport layer, the perovskite layer, and the hole transport layer have identical shapes and areas; and
either side of the second electrode layer is in lap joint with the first electrode layer, and electrodes are led out through the electrode leads at the two sides of the first electrode layer; an area of the barrier layer is greater than or equal to an area of the PI layer, and the area of the PI layer is greater than or equal to the area of the first electrode layer; and an area of the first protective film is equal to the area of the barrier layer.

3. The encapsulation structure of a flexible perovskite photovoltaic module according to claim 1, wherein the electrode leads are led out from the two opposite sides of the first electrode layer through methods of printing or attaching auxiliary electrodes.

4. A manufacturing method of an encapsulation structure of a flexible perovskite photovoltaic module, the encapsulation structure of a flexible perovskite photovoltaic module is the encapsulation structure of a flexible perovskite photovoltaic module according to any one of claims 1 to 3, specifically comprising:
step 1, manufacturing a PI layer: coating a glass substrate with a polyamic acid solution, heating to a specified temperature, performing annealing and forming a glass substrate with the transparent PI layer;
step 2, manufacturing a barrier layer: depositing at least one barrier layer for preventing moisture and oxygen permeation on the PI layer;
step 3, manufacturing a functional layer: sequentially manufacturing a first electrode layer, a hole transport layer, a perovskite layer, an electron transport layer, and a second electrode layer on the barrier layer;
step 4, manufacturing an encapsulation layer: manufacturing thin films on the functional layer by alternately compounding organic layers and inorganic layers by adopting a thin film encapsulation method, reserving positions for printing or attaching electrode leads at the first electrode layer, and attaching a second protective film to an upper surface of the manufactured encapsulation layer;
step 5, manufacturing a flexible substrate: peeling the glass substrate off the PI layer, obtaining the flexible substrate, and attaching a first protective film to a lower surface of the PI layer; and
step 6, leading out the electrode leads: leading out the electrode leads from two opposite sides of the first electrode layer by printing or attaching the electrode leads, and completing manufacturing of the encapsulation structure of a flexible perovskite photovoltaic module.

5. The manufacturing method of an encapsulation structure of a flexible perovskite photovoltaic module according to claim 4, wherein in step 1, the specified temperature is 300°C to 450°C.

6. The manufacturing method of an encapsulation structure of a flexible perovskite photovoltaic module according to claim 4, wherein in step 2, a thickness of the barrier layer is 100 nm to 500 nm.

7. The manufacturing method of an encapsulation structure of a flexible perovskite photovoltaic module according to claim 4, wherein in step 4, a material of the inorganic layers comprises, but is not limited to, silicon nitride, silicon dioxide, and aluminum trioxide, and a material of the organic layers comprises, but is not limited to, epoxy resin, organosilicon, propyl ethylacetate, and acrylate.

8. The manufacturing method of an encapsulation structure of a flexible perovskite photovoltaic module according to claim 4, wherein in step 4, a material of the second protective film comprises, but is not limited to, TPT, TPE, TPC, CPC, PET, PA/PO, and ultra-thin glass.

9. The manufacturing method of an encapsulation structure of a flexible perovskite photovoltaic module according to claim 4, wherein in step 5, the glass substrate is peeled off the PI layer through laser irradiation.

10. The manufacturing method of an encapsulation structure of a flexible perovskite photovoltaic module according to claim 4, wherein in step 5, a material of the first protective film comprises, but is not limited to, TPT, TPE, TPC, CPC, PET, PA/PO, and ultra-thin glass.
